# EUROPÄISCHE PATENTSCHRIFT

(11) **EP 3 475 740 B1**
(45) Veröffentlichungstag und Bekanntmachung des Hinweises auf die Patenterteilung: **18.12.2024**
(21) Anmeldenummer: 17726588.1
(22) Anmeldetag: 22.05.2017
(51) Int. Cl.: G02B 1/14, C09D 4/00, C09D 5/20

(54) **TEMPORÄRER SCHUTZLACK FÜR OPTIKELEMENT**
TEMPORARY PROTECTIVE LACQUER FOR OPTICAL ELEMENT
VERNIS PROTECTEUR TEMPORAIRE POUR ÉLÉMENT OPTIQUE

(30) Priorität: 22.06.2016 DE 102016111418
(43) Veröffentlichungstag der Anmeldung: 01.05.2019
(73) Patentinhaber: Tooz Technologies GmbH, 73430 Aalen (DE)
(72) Erfinder: PÜTZ, Jörg, 73431 Aalen (DE); WEIPPERT, Hans-Joachim, 73431 Aalen (DE); KRIEG, Matthias, 89522 Heidenheim (DE)
(74) Vertreter: Patentanwälte Geyer, Fehners & Partner mbB
(86) Internationale Anmeldenummer: PCT/EP2017/062237
(87) Internationale Veröffentlichungsnummer: WO 2017/220271

(56) Entgegenhaltungen:
- EP-A1- 2 065 414
- DE-A1- 102012 210 185
- US-A1- 2016 032 160

## Beschreibung

Die Erfindung bezieht sich auf eine Lackzusammensetzung, aus der durch Polymerisation ein Schutzlack hergestellt werden kann und die Verwendung der Lackzusammensetzung als temporärer Schutzlack für optische Flächen von Optikelementen. Die Erfindung bezieht sich weiter auf ein Optikelement, das den Schutzlack umfasst.

Komplexe optische Bauteile, wie sie beispielsweise in Datenbrillen zur Einspielung von Bildinformationen eingesetzt werden, enthalten oft unterschiedliche Funktionsflächen auf engstem Raum und in direkter Nachbarschaft. So kann es vorkommen, dass die transmissive Einkoppelfläche unmittelbar neben einer reflektierenden Fläche liegt. In der Regel werden im Herstellungsprozess solcher Optikelemente nicht-funktionelle Flächen mit einem Absorberlack z. B. einem hoch absorbierenden Schwarzlack überzogen, der Falschlicht eliminieren soll. Der Absorberlack wird dabei vorteilhaft ebenfalls auf hochreflektierenden Flächen aufgebracht, um diese vor Umwelteinflüssen zu schützen.

Zusammensetzungen des Stands der Technik sind aus DE 10 2012 210185 A1 und EP 2 065 414 A1 bekannt.

Die Fertigung und Veredelung solcher Optikelemente gestaltet sich unter anderem dadurch schwierig, dass einerseits reflektierende und nicht-funktionelle Flächen randscharf mit dem Absorberlack beschichtet werden sollen, andererseits dürfen transmissive Flächen, wie z. B. eine Einkoppelfläche und eine eventuell vorhandene Auskoppelfläche nicht mit dem Absorberlack kontaminiert werden, um keine Transmission zu verlieren oder Bildfehler zu erzeugen.

Aufgabe der Erfindung ist es daher, optische Flächen von Optikelementen in deren Herstellungsprozess zuverlässig vor chemischen und physikalischen Einflüssen zu schützen, wobei sich der Schutz zielgenau aufbringen und rückstandsfrei wieder entfernen lässt.

Erfindungsgemäß wird diese Aufgabe gelöst durch eine Lackzusammensetzung, umfassend
(A) 20 - 79,9 Gew.-%, bezogen auf das Gesamtgewicht der Zusammensetzung, einer Thiolverbindung mit zwei oder mehr Thiolgruppen,
(B) 20 - 79,9 Gew.-%, bezogen auf das Gesamtgewicht der Zusammensetzung, einer Verbindung mit zwei oder mehr Kohlenstoff-Kohlenstoff-Doppelbindungen und
(C) 0,2 - 10 Gew.-%, bezogen auf das Gesamtgewicht der Zusammensetzung, eines

Trennmittels, das mindestens einen Alkylrest mit 4-20 Kohlenstoffatomen aufweist, wobei der Alkylrest unsubstituiert oder mit Fluor substituiert ist und der Alkylrest an eine funktionelle Gruppe gebunden ist, wobei das Trennmittel aus einer Gruppe gewählt ist, bestehend aus Alkylmercaptan, Alken, primäres Alkylamin, sekundäres Alkylamin, tertiäres Alkylamin, Alkylphosphat, Dialkylphosphat und Trialkylphosphat.

Die Aufgabe wird weiter gelöst durch die Verwendung dieser Lackzusammensetzung als Schutzlack, der durch Abziehen wieder entfernbar ist, auf einer optischen Fläche eines Optikelements bei dessen Herstellung. Weiter wird die Aufgabe gelöst durch ein Optikelement mit einer optischen Fläche, wobei auf zumindest einem Teil der optischen Fläche der Schutzlack aufgebracht ist.

Überraschenderweise lässt sich aus der erfindungsgemäßen Lackzusammensetzung ein Schutzlack erzeugen, der eine hervorragende Balance zwischen der Anhaftung an optische Flächen von Optikelementen zu deren Schutz und der Ablösbarkeit bietet. Dabei wird eine optische Fläche von Optikelementen zuverlässig gegenüber nachfolgenden Prozessen wie der Beschichtung oder Reinigung, die oft Nassprozessschritte oder Behandlungen im Vakuum oder mittels Plasma beinhalten, abgedichtet und der Schutzlack ist gegenüber nachfolgenden Prozessschritten wie beispielsweise thermischen Behandlungen oder chemischen Reagenzien und Lösungsmitteln stabil. Auf der anderen Seite greift der Schutzlack die optischen Flächen von üblichen Optikelementen chemisch nicht an und er ist nach dem Prozessieren durch mechanische Einwirkung leicht wieder entfernbar (abziehbar).

Das entwickelte Polymersystem basiert auf dem Prinzip der radikalischen Polymerisation von Thiol-En-Systemen. Diesen wird erfindungsgemäß eine definierte Menge eines Trennmittels zugesetzt. Das Trennmittel ist eine Verbindung, die einen oder mehrere Alkylrest(e) mit 4-20 Kohlenstoffatomen an einer funktionellen Gruppe aufweist. Ohne erfindungsgemäß daran gebunden zu sein, wird angenommen, dass sich das Trennmittel im Verlauf des Härtungsprozesses an der Grenzfläche anreichert, wodurch der Schutzlack von einer zu schützenden optischen Fläche problemlos wieder entfernt werden kann.

Unter "enthaltend" eine Verbindung, beispielsweise eine Thiolverbindung, wird wie üblich verstanden, dass die Zusammensetzung ein oder mehrere dieser Verbindungen enthält oder umfasst. In diesem Sinne betrifft die Erfindung eine Zusammensetzung, umfassend ein oder mehrere Thiolverbindungen mit jeweils zwei oder mehr Thiolgruppen, ein oder mehrere Verbindungen mit zwei oder mehr Kohlenstoff-Kohlenstoff-Doppelbindungen und ein oder mehrere Trennmittel, die jeweils einen oder mehrere Alkylrest(e) mit 4-20 Kohlenstoffatomen aufweisen, wobei der Alkylrest an eine funktionelle Gruppe gebunden ist. Unter einem Alkylrest oder einer Alkylgruppe wird eine Gruppe aus Kohlenstoff- und Wasserstoffatomen verstanden, die nicht aromatisch ist, wobei ein Alkylrest im Sinne der Erfindung auch eine oder mehrere Doppelbindung enthalten kann, d. h. ein Alkan- oder Alkenrest sein kann. Die Alkylgruppe oder der Alkylrest kann unsubstituiert oder mit Fluor substituiert sein. Unter den fluorierten Alkylresten sind teilfluorierte Alkylreste bevorzugt, d. h. es ist nur ein Teil der Wasserstoffatome durch Fluor substituiert.

Die Komponente (A) ist eine Thiolverbindung mit zwei oder mehr Thiolgruppen (-SH-Gruppen). Bevorzugte Thiolverbindugen sind Mercaptoester und hier insbesondere Mercaptoester mit zwei oder mehr Estergruppen und zwei oder mehr Thiolgruppen. Bevorzugte Mercaptoester sind Mercaptoacetate, 2- und 3-Mercaptopropionate, die eine vorteilhafte Reaktivität in Kombination mit den weiteren Komponenten der erfindungsgemäßen Lackzusammensetzung aufweisen. Weiter bevorzugt sind Mercaptoester, deren Carbonsäuregruppen mit polyfunktionellen Alkoholen verestert sind. Bevorzugte polyfunktionelle Alkohole sind die nachfolgend in Form ihrer Mercaptoester genannten polyfunktionellen Alkohole. Bevorzugt sind Mercaptoester mit 3 oder mehr Thiolgruppen und 3 oder mehr Estergruppen, insbesondere Pentaerythritol-tetra-(3-mercaptopropionat) (PTMP), Trimethylolpropan-tri-(3-mercaptopropionat) (TPMP), Ethylenglycol-di-(3-mercaptopropionat) (GDMP), Pentaerythritol-tetra-(mercaptoacetat) (PTMA), Trimethylol¬propan-tri-(mercaptoacetat) (TPMA), Ethylenglycol-di-(mercaptoacetat) (GDMA), Tris-[2-(3-mercapto¬propionyl¬oxy)-ethyl]-isocyanurat (TEMPIC) und Tris-[2-(2-mercaptopropionyloxy)-ethyl]-isocyanurat (TETLIC). Als besonders vorteilhaft haben sich Tris-[2-(3-mercaptopropionyloxy)-ethyl]-isocyanurat und Trimethylolpropan-tri-(3-mercaptopropionat) erwiesen.

In einer weiteren bevorzugten Ausgestaltung der Erfindung ist die Komponente (A) ein Thioether, der zwei oder mehr Thiolgruppen aufweist. Ein solcher Thioether enthält somit die Gruppierung RSR' und zwei oder mehr freie SH-Gruppen. Ein Beispiel für einen Thioether ist 2,3-Bis(2-Mercaptoethylsulfanyl)-propan-1-thiol.

Die Komponente (A) liegt in einer Menge von 20 - 79,9 Gew.-% vor, bezogen auf das Gesamtgewicht der Lackzusammensetzung. Bevorzugt sind 25-74,9 Gew.-%, insbesondere 30-69,9 Gew.-%.

Die Komponente (B) ist eine Verbindung mit zwei oder mehr Kohlenstoff-Kohlenstoff-Doppelbindungen. Bevorzugt sind insbesondere im Hinblick auf die Reaktivität Verbindungen mit endständiger Kohlenstoff-Kohlenstoff-Doppelbindung wie Acrylate und Methacrylate, Vinyl- und Vinyloxyverbindungen, sowie insbesondere Allylderivate. Hierunter bevorzugt sind Allylester der Phthalsäure, iso-Phthalsäure und Terephthalsäure, Allylether von Pentaerythritol und Trimethylolpropan, sowie 2,4,6-Triallyloxy-1,3,5-triazin. Mit besonderem Vorteil kann 1,3,5-Triallyl-1,3,5-triazin-2,4,6-trion eingesetzt werden. 1,3,5-Triallyl-1,3,5-triazin-2,4,6-trion kann insbesondere in Kombination mit den oben genannten Mercaptoestern eingesetzt werden und hier insbesondere zusammen mit Tris-[2-(3-mercaptopropionyloxy)-ethyl]-isocyanurat und/oder Trimethylolpropan-tri-(3-mercaptopropionat). Die Komponente (B) liegt in einer Menge von 20 - 79,9 Gew.-% vor, bezogen auf das Gesamtgewicht der Lackzusammensetzung. Bevorzugt sind 25 - 74,9 Gew.-%, insbesondere 30 - 69,9 Gew.-%.

Es versteht sich, dass die Komponenten (A), (B) und (C) der erfindungsgemäßen Lackzusammensetzung, gegebenenfalls mit weiteren Komponenten der Zusammensetzung, zusammen 100 Gew.-% ausmachen. Von den 20 - 79,9 Gew.-% der Thiolverbindung mit zwei oder mehr Thiolgruppen (A), den 20 - 79,9 Gew.-% der Verbindung mit zwei oder mehr Kohlenstoff-Kohlenstoff-Doppelbindungen (B), und den 0,1 - 10 Gew.-% Trennmittel (C) wird der Fachmann somit Mengen auswählen, dass zusammen mit eventuell vorhandenen weiteren Komponenten wie Additiven, Füllstoffen, Lösungsmitteln, Oligomeren etc. zusammen 100 Gew.-% entstehen.

Eine zentrale Rolle kommt in der erfindungsgemäßen Lackzusammensetzung der Komponente (C) zu, dem Trennmittel, das einen Alkylrest mit 4-20 Kohlenstoffatomen aufweist, wobei der Alkylrest an eine funktionelle Gruppe gebunden ist. Das Trennmittel kann mehrere Alkylgruppen enthalten, die dann jeweils 4-20 Kohlenstoffatome aufweisen und an die funktionelle Gruppe gebunden sind. Dieses Trennmittel sorgt dafür, dass der aus der Lackzusammensetzung herstellbare Schutzlack wieder gut entfernt werden kann, insbesondere von optischen Flächen von Optikelementen.

Der Alkylrest der Komponente (C) kann gesättigt oder ungesättigt sein. Er kann ferner unverzweigt, verzweigt oder cyclisch sein. Beispiele für gesättigte Alkylreste sind Butyl, Pentyl, Hexyl, Heptyl, Octyl, Nonyl, Decyl, Undecyl, Dodecyl, Tridecyl, Tetradecyl, Pentadecyl, Hexadecyl, Heptadecyl, Octadecyl, Nonadecyl und Eicosyl. Bevorzugt sind 1-Alkylreste. In einer bevorzugten Ausgestaltung der Erfindung weist das Trennmittel (C) einen oder mehrere Alkylreste auf, wobei der eine Alkylrest 7-20 Kohlenstoffatome oder die mehreren Alkylreste zusammen 7-20 Kohlenstoffatome aufweisen. Beispiele für ein Trennmittel mit 8 Kohlenstoffatomen wäre Octylamin oder Dibutylamin oder Dibutylphosphat. Die mehreren Alkylreste können die gleiche oder unterschiedliche Längen aufweisen. Eine Dialkylverbindung als Trennmittel mit zusammen 8 Kohlenstoffatomen könnte beispielsweise einen Rest mit 2 und einen mit 6 Kohlenstoffatomen, einen Rest mit 3 und einen mit 5 Kohlenstoffatomen oder zwei Reste mit 4 Kohlenstoffatomen aufweisen. Besonders bevorzugt sind Trennmittel mit einem oder mehreren Alkylresten, wobei der eine Alkylrest oder die mehreren Alkylreste zusammen 8-16 Kohlenstoffatome aufweisen. Am meisten bevorzugte Trennmittel sind Dodecylamin und Dibutylphospat.

Das Trennmittel kann als Additiv in der Lackzusammensetzung vorliegen, d. h. es wird nicht mit einpolymerisiert. Erfindungsgemäß sind die Amine und Phosphate, d. h. die Trennmittel sind Alkylamine wie primäre Alkylamine (Monoalkylamin), sekundäre Alkylamine (Dialkylamin) oder tertiäre Alkylamine (Trialkylamin), Alkylphosphate, Dialkylphosphate und Trialkylphosphate. Unter diesen Alkylaminen, die als Additive vorliegen, sind Dodecylamin, Tetradecylamin und Hexadecylamin besonders bevorzugt.

Ein als Additiv vorliegendes Trennmittel bildet nach dem Abziehen des Polymers in Form des Schutzlacks in der Regel einen Rückstandsfilm, den man im Herstellungsprozess beispielsweise mit einem Tuch abwischen kann.

Mit besonderem Vorteil kann das Trennmittel eine reaktive Funktionalität aufweisen, d. h. es wird bei der Polymerisation der Lackzusammensetzung mit einpolymerisiert, wodurch eine besonders rückstandsarme Entfernung des Schutzlackes ermöglicht wird. Vorzugsweise ist hier die funktionelle Gruppe eine Thiol- oder Mercaptangruppe (-SH) oder eine Kohlenstoff-Kohlenstoff-Doppelbindung, d. h. das Trennmittel ist ein Alkylmercaptan oder ein Alken. Bei diesen kann der Alkylrest wieder wie oben beschrieben aufgebaut sein. Bevorzugt sind 1-Alkylmercaptane mit 7-20 Kohlenstoffatomen, insbesondere mit 8-18 Kohlenstoffatomen und am meisten bevorzugt mit 10-16 Kohlenstoffatomen. Besonders bevorzugte Trennmittel sind 1-Decylmercaptan, 1-Dodecylmercaptan, 1-Tetradecylmercaptan und 1-Hexadecylmercaptan. Als Alkene eignen sich insbesondere solche mit endständiger Doppelbindung, d. h. die funktionelle Gruppe ist eine Vinylgruppe. Somit kann das Trennmittel vorzugsweise ein 1-Alken mit 9-22 Kohlenstoffatomen, insbesondere 10-20 Kohlenstoffatomen und am meisten bevorzugt 12-18 Kohlenstoffatomen sein, insbesondere 1-Dodecen, 1-Tetradecen, 1-Hexadecen und 1-Octadecen.

Eine weitere Möglichkeit ist ein chemisch bereits vernetztes Trennmittel z. B. eines oligomeren (präpolymeren) Polythiols, das durch die Reaktion eines 1-Mercaptoalkans mit einem Unterschuss eines geeigneten Diisocyanats erhalten wird. Es ist ebenfalls möglich Präpolymere aus polyfunktionellen Thiolen durch Umsetzung mit einem Unterschuss an einem 1-Alkylisocynat wie z. B. Octadecylisocyanat einzusetzen.

Das Trennmittel liegt in der erfindungsgemäßen Lackzusammensetzung in einer Menge von 0,2 - 10 Gew.-% vor, bezogen auf das Gesamtgewicht der Zusammensetzung. Bevorzugt sind 0,2 - 5 Gew.-%, insbesondere 0,5 - 3 Gew.-%.

Eine bevorzugte Lackzusammensetzung umfasst:
(A) 30 - 69,8 Gew.-%, bezogen auf das Gesamtgewicht der Zusammensetzung, einer Thiolverbindung mit zwei oder mehr Thiolgruppen,
(B) 30 - 69,8 Gew.-%, bezogen auf das Gesamtgewicht der Zusammensetzung, einer Verbindung mit zwei oder mehr Kohlenstoff-Kohlenstoff-Doppelbindungen und
(C) 0,2 - 5 Gew.-%, bezogen auf das Gesamtgewicht der Zusammensetzung, eines Trennmittels, das einen Alkylrest mit 4-20 Kohlenstoffatomen aufweist, wobei der Alkylrest unsubstituiert oder mit Fluor substituiert ist und der Alkylrest an eine funktionelle Gruppe gebunden ist.

Der Lack kann eher dünnflüssig ausgelegt werden, um eine optische Fläche, beispielsweise in Form einer Vertiefung möglichst rasch und vollständig ausfüllen zu können. In anderen Ausführungsformen kann es von Vorteil sein, eine höhere Viskosität einzustellen, um beispielsweise eine selektive Belegung einer optischen Fläche zu erzielen. Für eine höhere Viskosität kann in einer vorteilhaften Ausgestaltung der Lackzusammensetzung ein Oligomer zugesetzt werden. Unter einem Oligomer wird im Sinne der Erfindung eine organische Verbindung verstanden, die aus sich wiederholenden Einheiten von Monomeren aufgebaut ist, wobei die Zahl der Monomere (Summe aller Monomere) im Zahlenmittel 3-100 beträgt, insbesondere 5-70. Dieses Oligomer wird nachfolgend auch als Präpolymer bezeichnet.

In einer bevorzugten Ausgestaltung der Erfindung ist für eine erhöhte Viskosität die Komponente (A) ein Oligomer. Vorzugsweise weist die Lackzusammensetzung daher 20-79,9 Gew.-% eines Oligomers bzw. Präpolymers auf, bezogen auf das Gesamtgewicht der Lackzusammensetzung, insbesondere 30-69,5 Gew.-%.

Das Oligomer ist vorzugsweise ein oligomeres Thiourethan, insbesondere mit freien Thiolgruppen. Thiourethane sind dem Fachmann bekannt. Sie lassen sich aus einem Thiol und einem Isocyanat herstellen. Bevorzugt sind oligomere Thiourethane aus einem Mercaptoester, mit zwei oder mehr Thiolgruppen (Mercaptoestermonomer) und einem Isocyanat mit zwei oder mehr Isocyanatgruppen (Isocyanatmonomer). Weiter bevorzugt sind oligomere Thiourethane aus einem Thioether mit zwei oder mehr Thiolgruppen und einem Isocyanat mit zwei oder mehr Isocyanatgruppen. Beispiele für Isocyanate sind TDI (Toluol-2,4-diisocyanat), HMDI (Hexamethylendiisocyanat) und MDI (Methylendiphenyldiisocyanat).

Dabei beträgt die Anzahl der im Oligomer enthaltenen Thiol- und Isocyanatmonomeren in der Summe im Zahlenmittel 3 - 100. In diesem Sinne würde beispielsweise das Oligomer PTMP - XDI - PTMP - XDI - PTMP 5 Monomere umfassen. Bevorzugt sind Oligomere aus Pentaerythritol-tetra-(3-mercaptopropionat) (PTMP) mit Xylylendiisocyanat (XDI), aus Pentaerythritol-tetra-(3-mercaptopropionat) mit Norbornyldiisocyanat (NBDI) oder aus Pentaerythritol-tetra-(3-mercaptopropionat) mit Isophorondiisocyanat (IPDI) sowie Oligomere aus Trimethylolpropan-tri-(3-mercaptopropionat) (TPMP) mit Xylylendiisocyanat, aus Trimethylolpropan-tri-(3-mercaptopropionat) mit Norbornyldiisocyanat (NBDI) oder aus Trimethylolpropan-tri-(3-mercaptopropionat) mit Isophorondiisocyanat (IPDI). Vorzugsweise ist in diesen Oligomeren das Verhältnis aus Mercaptopropionat und Diisocyanat 20:1 bis 5:1, damit die Isocyanatgruppen vollständig umgesetzt sind.

### Beispiel PTMP/XDI:

| | |
|---|---|
| PTMP | Molekulargewicht 488 g/mol, 4 SH-Gruppen |
| XDI | Molekulargewicht 188 g/mol, 2 NCO-Gruppen |

Herstellung der Oligomere: Das Polythiol wird im stöchiometrischen Überschuss unter Schutzgas mit dem Isocyanat vollständig umgesetzt. Kontrolle durch IR-Spektroskopie (NCO-Bande bei ca. 2262 cm⁻¹, Erfassungsgrenze bei 50 µm Schichtdicke liegt bei ca. 0,02 Gew% freies NCO).
Präpolymer PTMP/XDI 100+10: es sind 13,0% der SH-Gruppen umgesetzt.
Präpolymer PTMP/XDI 100+15: Es sind 19,5% der SH-Gruppen umgesetzt.
Präpolymer PTMP/XDI 100+20: Es sind 26,0% der SH-Gruppen umgesetzt.

Das Verhältnis PTMP zu XDI orientiert sich an der Viskosität der Präpolymere/Oligomere, die sich bei der Umsetzung ergeben, die damit die Viskosität der resultierenden Lackzusammensetzung maßgeblich beeinflussen.

In einer bevorzugten Ausgestaltung der Erfindung ist die Thiolverbindung somit ein oligomeres Thiourethan, erhältlich durch Umsetzung mindestens eines Mercaptoesters, der zwei oder mehr Estergruppen und zwei oder mehr Thiolgruppen aufweist, mit mindestens einem Di- oder Polyisocyanat, wobei das entstehende oligomere Thiourethan zwei oder mehr freie Thiolgruppen aufweist. Alternativ wird zusätzlich zu einer monomeren Mercaptoesterverbindung ein oligomeres Thiourethan zu der Lackzusammensetzung hinzugefügt, wobei das oligomere Thiourethan wiederum erhältlich ist durch Umsetzung mindestens eines Mercaptoesters, der zwei oder mehr Estergruppen und zwei oder mehr Thiolgruppen aufweist, mit mindestens einem Di- oder Polyisocyanat, wobei das oligomere Thiourethan zwei oder mehr freie Thiolgruppen aufweist. Das oligomere Thiourethan kann auch eine Mischung aus zwei oder mehr oligomeren Thiourethanen sein. Die oligomeren Thiourethane sind vorzugsweise jeweils erhältlich wie oben beschrieben. Ein hinzugefügtes Oligomer bzw. Präpolymer wird, bezogen auf das Gesamtgewicht der Lackzusammensetzung, vorzugsweise in einer Menge von 10-30 Gew.-% hinzugefügt.

In einer weiteren vorteilhaften Ausgestaltung wird der erfindungsgemäßen Lackzusammensetzung zusätzlich ein Füllstoff hinzugefügt, wodurch der Schrumpf des Schutzlackes bei der Aushärtung vermindert werden kann. Dadurch wird insbesondere ein Ablösen des Schutzlacks von einer Oberfläche während des Aushärtens verhindert, so dass z. B. bei einem Optikelement von einem anschließend aufzubringenden Absorberlack keine Lackspuren zwischen die optische Fläche und den aufgebrachten Schutzlack gelangen können. Als vorteilhaft haben sich 5-25 Gew.-% Füllstoff, bezogen auf das Gesamtgewicht der Lackzusammensetzung, erwiesen, insbesondere 10-20 Gew.-%. Ein bevorzugter Füllstoff ist Quarzmehl oder Quarzgutmehl, insbesondere silanisiertes Quarzmehl bzw. Quarzgutmehl, vorzugsweise mit einer mittleren Partikelgröße von 4-6 µm. Als Silanisierungsbeschichtung kommen Alkyl-, Glycidyl-, Acryl-/Methacryl- und Mercaptosilane in Frage. Bevorzugt sind als Füllstoff ferner Polymere, insbesondere Polyvinylacetat oder Ketonharze in reiner oder hydrierter Form, wodurch der zu erzeugende Schutzlack besonders flexibel gehalten werden kann.

Die erfindungsgemäße Lackzusammensetzung kann ferner übliche Additive enthalten, beispielsweise Stabilisatoren und Fotoinitiatoren. Stabilisatoren sind Radikalfänger, die dafür sorgen, dass die Mischung aus der polyfunktionellen Thiolverbindung und der Verbindung mit zwei oder mehr Kohlenstoff-Kohlenstoff-Doppelbindungen nicht von sich aus polymerisiert. Bevorzugt werden sterisch gehinderte Hydrochinone oder Phenole eingesetzt, besonders bevorzugte Stabilisatoren sind dabei tert-Butylhydrochinon und 2,6-Di-tert-butyl-4-methylphenol (Butylhydroxytoluol, BHT). Als Stabilisator haben sich insbesondere Mengen von 0,2-3 Gew.-%, bezogen auf das Gesamtgewicht der Lackzusammensetzung, erwiesen.

Es kann grundsätzlich Lösungsmittel eingesetzt werden, um die Verarbeitungsviskosität zu regulieren oder auch um einen gleichmäßigen Verlauf nach Auftragen der Schutzbeschichtung zu gewährleisten. Bevorzugt ist es, dass die erfindungsgemäße Lackzusammensetzung wenig organisches Lösungsmittel enthält, damit optische Flächen nicht angegriffen werden. Die erfindungsgemäße Lackzusammensetzung umfasst insbesondere weniger als 1 Gew.-%, bezogen auf das Gesamtgewicht der Zusammensetzung, organisches Lösungsmittel, besonders bevorzugt weniger als 0,5 Gew.-%, am meisten bevorzugt weniger als 0,1 Gew.-%, und am meisten bevorzugt ist die Lackzusammensetzung frei von Lösungsmittel.

Ein organisches Lösungsmittel ist im Sinne der Erfindung wie üblich eine Kohlenstoff enthaltende Verbindung, die Gase, Flüssigkeiten oder Feststoffe lösen kann, ohne dass es dabei zu chemischen Reaktionen zwischen dem Lösungsmittel und dem gelösten Stoff kommt. Organische Lösungsmittel sind dem Fachmann hinreichend bekannt.

Im Sinne einer schnellen Prozessführung ist insbesondere eine UV-Härtung der erfindungsgemäßen Lackzusammensetzung von Vorteil, mit der sich eine ausreichende Härtung in relativ kurzen Zeiträumen realisieren lässt. Grundsätzlich ist auch eine thermische Härtung möglich oder eine Kombination aus diesen. Zur UV-Härtung werden vor der Polymerisation übliche Fotoinitiatoren zugesetzt, beispielsweise α-Hydroxyketone, wie zum Beispiel Irgacure 1116, Irgacure 1173 und Irgacure 2959, bevorzugt ist Irgacure 1173. Ferner sind α-Aminoketone, wie z. B. Irgacure 369, Irgacure 379, Irgacure 907 und Irgacure 1300, Benzyldimetylketale, wie z. B. Irgacure 651, Phenylglyoxylate, wie z. B. Irgacure 754, Mono-Acylphosphine, wie z. B. Irgacure TPO und Bis-Acylphosphine, wie z. B. Irgacure 819 und Irgacure 2100, sowie Benzophenone einsetzbar. Bei der thermischen Aushärtung werden bevorzugt Peroxide wie Di-tert-butylperoxid oder Dibenzoylperoxid sowie Azoverbindungen wie Azobisisobutyronitril eingesetzt.

Zudem können weitere Additive zugesetzt werden, wie z. B. Weichmacher oder Kunstharze, um die Viskosität an den gewünschten Einsatzzweck anzupassen. Des Weiteren kann es von Vorteil sein, der erfindungsgemäßen Lackzusammensetzung noch einen Farbstoff oder ein Farbpigment zuzusetzen, um den Schutzlack besser sichtbar zu machen, beispielsweise im Herstellungsprozess von Optikelementen. Als besonders geeignet haben sich Seriplas Red X3B-TP und Sudanblau erwiesen. Hierbei sollten die Farbstoffe bzw. -pigmente bei der jeweiligen Anregungswellenlänge z. B. 365 nm hinreichend lichtdurchlässig, also transparent, sein.

Die Erfindung betrifft ferner ein Verfahren zur Herstellung eines Schutzlacks, umfassend die Schritte, dass die erfindungsgemäße Lackzusammensetzung polymerisiert wird, beispielsweise thermisch oder mit Hilfe von Licht. Das erfindungsgemäße Verfahren zur Herstellung eines Schutzlacks, umfasst insbesondere die Schritte, dass die erfindungsgemäße Lackzusammensetzung mit einem Fotoinitiator vermischt und anschließend mit Licht einer Wellenlänge ≤ 450 nm bestrahlt wird, wobei die Zusammensetzung polymerisiert und aushärtet. Alternativ kann die erfindungsgemäße Zusammensetzung mit einem üblichen Radikalstarter versetzt und erwärmt werden (thermische Polymerisation).

Weiter betrifft die Erfindung die Verwendung der erfindungsgemäßen Lackzusammensetzung als Schutzlack, insbesondere als Schutzlack auf einer optischen Fläche eines Optikelements, insbesondere bei der Herstellung des Optikelements. Die Erfindung betrifft auch einen Schutzlack, herstellbar durch Polymerisieren der erfindungsgemäßen Lackzusammensetzung.

Die Erfindung betrifft auch ein Optikelement mit einer optischen Fläche, wobei zumindest ein Teil der optischen Fläche einen Schutzlack aufweist, herstellbar durch Polymerisieren der erfindungsgemäßen Lackzusammensetzung. Wenn ein Teil einer Fläche einen Schutzlack aufweist wird darunter im Sinne der Erfindung verstanden, dass zumindest ein Teil der Fläche mit einem Schutzlack überzogen ist. Bevorzugt ist es, dass die gesamte Fläche mit dem Schutzlack überzogen oder bedeckt ist. In einer bevorzugten Ausgestaltung der Erfindung ist die optische Fläche durch einen umlaufenden erhöhten Rand begrenzt und der Schutzlack wird in die sich daraus ergebende Vertiefung eingebracht.

Die optische Fläche des Optikelements kann selektiv mit dem Schutzlack belegt werden, der aus der erfindungsgemäßen Lackzusammensetzung herstellbar ist. Der umgebende Bereich kann dabei so gestaltet werden, dass die Aufbringung sowie die Schutzfunktion des Schutzlacks begünstigt wird. So kann die Fläche beispielsweise erweitert werden, um die Schutzfunktion über den Schichtrand hinaus sicher zu stellen. Es kann auch vorteilhaft sein, den umgebenden Rand als umlaufende Erhöhung auszugestalten, so dass sich eine Vertiefung ausbildet, beispielsweise in Form eines Troges, der den Lack aufnehmen kann. Hierdurch bildet sich ein definierter Pfropfen aus, der sowohl die zu schützende Schicht als auch die begrenzenden Seitenwände abdeckt. Der flüssige Lack bzw. das flüssige Reaktivharz kann dann nach der Aufbringung der optischen Schicht in die Vertiefung eingefüllt und ausgehärtet werden. Nach der vollständigen Prozessierung des Bauteils kann der Pfropfen samt der eventuell darauf aufgebrachten Lacke und Schichten entfernt werden, wobei die zuvor aufgebrachte optische Schicht unversehrt wieder freigelegt wird.

Um die Schutzfunktion des Abziehlacks zu gewährleisten, kann es vorteilhaft sein, den Schutzlack über den Rand der eigentlichen Funktionsschicht hinaus aufzubringen. Um eine einheitliche Anhaftung bzw. Entformung zu erreichen, kann die Funktionsschicht auch größer ausgelegt werden, so dass der Schutzlack zwar über den optisch genutzten Bereich der Schicht hinausgeht, jedoch eine einheitliche Oberfläche bedeckt. Dies kann auch im Falle einer Vertiefung oder eines Troges erreicht werden, indem die optische Schicht die gesamte Innenfläche des Troges bedeckt.

Der Schutzlack hat vorzugsweise eine Dicke von 0,2 - 2,5 mm. Unter der Dicke wird dabei die maximale Dicke verstanden, beispielsweise bei einem schichtförmig ausgebildeten Schutzlack die größte Höhe der Schicht. Besonders bevorzugt ist eine Dicke von 0,5 - 1,5 mm.

Der Schutzlack, der durch Polymerisieren der erfindungsgemäßen Lackzusammensetzung herstellbar ist, ist durch Abziehen wieder entfernbar. Zur Vereinfachung der späteren Entfernung kann es hilfreich sein, ein entsprechendes Hilfsmittel in den Schutzlack mit einzupolymerisieren. Vorteilhafterweise kann eine Schlaufe oder ein Stift mit eingebettet werden, an dem der zu entfernende Schutzlack abgezogen werden kann.

Das Optikelement kann aus den üblichen optischen Materialien bestehen. Hierzu zählen neben Mineralgläsern und keramischen Materialien vor allem auch Polymere. Als Beispiele sind Thermoplaste wie PMMA (Polymethylmethacrylat), PET (Polyethylenterephthalat), PC (Polycarbonat), COP/COC (Cycloolefinpolymere/Cycloolefincopolymere), PS (Polystyrol), PA (Polyamide) aber auch Duroplaste wie ADC (Allyldiglykolcarbonat), PUR (Polyurethane), PU (Polyharnstoffe), PTU (Polythiourethane) und Elastomere wie LSR (Liquid Silicone Rubber) zu nennen.

Das Optikelement kann beispielsweise eine Linse, Prisma, ein optisches Element einer Abbildungsoptik, Projektions- oder Aufnahmeoptik, Teil eines Mikroskops etc. sein. In einer vorteilhaften Ausgestaltung der Erfindung ist das Optikelement als Brillenglas für eine auf den Kopf eines Benutzers aufsetzbare und ein Bild erzeugende Anzeigevorrichtung ausgebildet, wobei das Optikelement eine Vorderseite und eine Rückseite aufweist, die optische Fläche eine Einkoppelfläche ist und das Optikelement einen von der Einkoppelfläche beabstandeten Auskoppelabschnitt und einen Lichtführungskanal aufweist, der dazu geeignet ist, Lichtbündel von Pixeln des erzeugten Bildes, die über die Einkoppelfläche des Optikelementes in das Optikelement eingekoppelt sind, im Optikelement bis zum Auskoppelabschnitt zu führen, von dem sie aus dem Optikelement ausgekoppelt werden. Die Einkoppelfläche weist auf zumindest einem Teil ihrer Oberfläche einen Schutzlack auf, herstellbar durch Polymerisieren der erfindungsgemäßen Lackzusammensetzung. Der Schutzlack ist ein temporärer Schutzlack, d. h. er wird im Herstellungsprozess zum Schutz optischer Flächen, beispielsweise Einkoppelflächen eingesetzt und später wieder entfernt.

Des Weiteren wird eine Anzeigevorrichtung mit einer auf den Kopf eines Benutzers aufsetzbaren Haltevorrichtung, einem an der Haltevorrichtung befestigten Bilderzeugungsmodul, das ein Bild erzeugt, und einer an der Haltevorrichtung befestigten Abbildungsoptik bereitgestellt, die ein erfindungsgemäßes Optikelement aufweist und die das erzeugte Bild im auf dem Kopf des Benutzers aufgesetzten Zustand der Haltevorrichtung so abbildet, dass es der Benutzer als virtuelles Bild wahrnehmen kann.

Die Abbildungsoptik kann das Optikelement als einziges optisches Element aufweisen. Es ist jedoch auch möglich, dass die Abbildungsoptik neben dem Optikelement noch zumindest ein weiteres optisches Element umfasst. Das zumindest eine weitere optische Element kann vom Optikelement beabstandet sein oder mit diesem direkt verbunden sein (z. B. verklebt oder verkittet).

Die Anzeigevorrichtung kann eine Steuereinheit aufweisen, die das Bilderzeugungsmodul ansteuert. Das Bilderzeugungsmodul kann insbesondere einen flächigen Bildgeber aufweisen, wie z. B. ein LCD-Modul, ein LCoS-Modul, ein OLED-Modul oder eine Kippspiegelmatrix. Der Bildgeber kann eine Mehrzahl von Pixeln aufweisen, die z. B. in Zeilen und Spalten angeordnet sein können. Der Bildgeber kann selbstleuchtend oder nicht selbstleuchtend sein. Das Bilderzeugungsmodul kann insbesondere so ausgebildet sein, dass es ein monochromatisches oder ein mehrfarbiges Bild erzeugt. Die Anzeigevorrichtung kann weitere, dem Fachmann bekannte Elemente aufweisen, die zu ihrem Betrieb notwendig sind.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

Nachfolgend wird die Erfindung beispielhaft anhand der beigefügten Zeichnungen, die auch erfindungswesentliche Merkmale offenbaren, noch näher erläutert. Zur besseren Anschaulichkeit wird in den Figuren zumindest teilweise auf eine maßstabs- und proportionsgetreue Darstellung und auf Schraffuren verzichtet. Es zeigen:
- Fig. 1: eine Ausführungsform der erfindungsgemäßen Anzeigevorrichtung;
- Fig. 2: eine vergrößerte Teilschnittansicht des erfindungsgemäßen Optikelementes 1 einschließlich einer schematischen Darstellung des Bilderzeugungsmoduls.

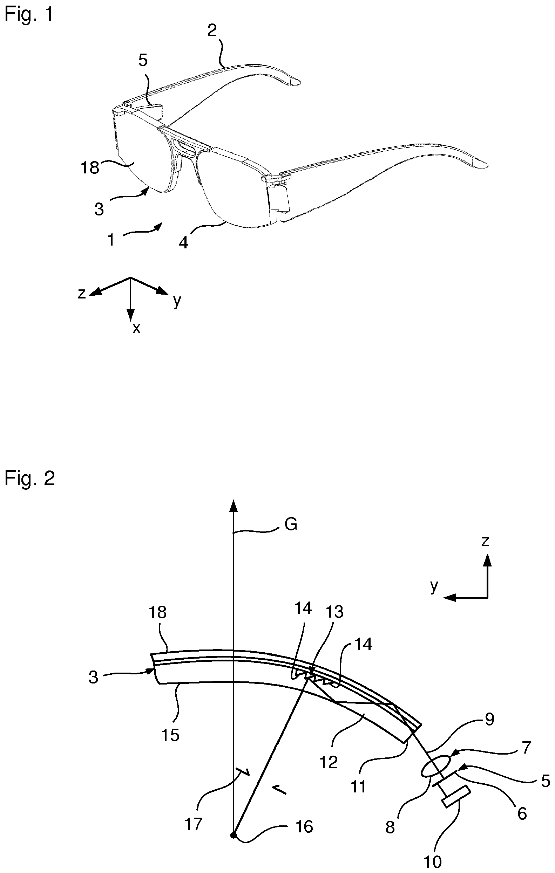

Bei der in Fig. 1 gezeigten Ausführungsform umfasst die erfindungsgemäße Anzeigevorrichtung 1 eine auf den Kopf eines Benutzers aufsetzbare Haltevorrichtung 2, die z. B. in Art eines herkömmlichen Brillengestells ausgebildet sein kann, sowie ein erstes und ein zweites Brillenglas 3, 4, die an der Haltevorrichtung 2 befestigt sind. Die Haltevorrichtung 2 mit den Brillengläsern 3, 4 kann z. B. als Sportbrille, Sonnenbrille und/oder Brille zur Korrektur einer Fehlsichtigkeit ausgebildet sein, wobei dem Benutzer über das erste Brillenglas 3 ein virtuelles Bild in sein Gesichtsfeld eingespiegelt werden kann, wie nachfolgend beschrieben wird.

Dazu umfasst die Anzeigevorrichtung 1 ein Bilderzeugungsmodul 5, das im Bereich des rechten Brillenbügels der Haltevorrichtung 2 angeordnet sein kann, wie in Fig. 1 schematisch dargestellt ist. Das Bilderzeugungsmodul 5 kann ein flächiges Bilderzeugungselement 6 (Fig. 2), wie z. B. einen OLED-, einen LCD- oder einen LCoS-Chip oder eine Kippspiegelmatrix, mit einer Vielzahl von z. B. in Spalten und Zeilen angeordneten Pixeln aufweisen.

Die Brillengläser 3 und 4 und insbesondere das erste Brillenglas 3 sind nur beispielshalber zusammen mit der erfindungsgemäßen Anzeigevorrichtung 1 beschrieben. Die Brillengläser 3, 4 bzw. zumindest das erste Brillenglas 3 sind jeweils für sich als erfindungsgemäßes Brillenglas 3, 4 oder als erfindungsgemäßes optisches Element ausgebildet. Das erfindungsgemäße optische Element kann auch in anderem Zusammenhang als mit der hier beschriebenen Anzeigevorrichtung 1 eingesetzt werden. Daher kann das optische Element, wenn es als Brillenglas ausgebildet ist, natürlich auch als zweites Brillenglas 4 ausgebildet sein.

Wie am besten aus der vergrößerten, schematischen Teilschnittansicht in Fig. 2 ersichtlich ist, weist die Anzeigevorrichtung 1 eine Abbildungsoptik 7 auf, die ein zwischen dem Bilderzeugungselement 6 bzw. dem Bildgeber 6 und dem ersten Brillenglas 3 angeordnetes Optikelement 8 enthält. Des Weiteren dient das erste Brillenglas 3 selbst auch als Teil der Abbildungsoptik 7.

Von jedem Pixel des Bildgebers 6 kann ein Lichtbündel 9 ausgehen. Durch eine entsprechende Ansteuerung der Pixel des Bildgebers 6 mittels einer Steuereinheit 10, die Teil des Bilderzeugungsmoduls 5 sein kann, kann das gewünschte Bild erzeugt werden. In Fig. 2 ist stellvertretend für die Lichtbündel 9 der Strahlengang eines Lichtstrahls eingezeichnet, so dass nachfolgend auch von dem Lichtstrahl 9 die Rede ist.

Der vom Bildgeber 6 ausgehende Lichtstrahl 9 läuft durch das Optikelement 8 und tritt über einen Einkoppelabschnitt 11 oder Einkoppelfläche 11 (hier die Stirnseite des ersten Brillenglases 3) in das erste Brillenglas 3 ein und wird in diesem entlang eines Lichtführungskanals 12 bis zu einem Auskoppelabschnitt 13 geführt. Der Auskoppelabschnitt 13 weist mehrere nebeneinander angeordnete reflektive Umlenkflächen 14 (die auch als reflektive Facetten bezeichnet werden können) auf, an denen eine Reflexion der Lichtstrahlen 9 in Richtung zu einer Rückseite 15 des ersten Brillenglases 3 stattfindet, so dass die Lichtstrahlen 9 über die Rückseite 15 aus dem ersten Brillenglas 3 austreten. Der Einkoppelabschnitt 11 oder die Einkoppelfläche 11 kann auch direkt mit dem Brillenglas 3 verbunden sein. Im Herstellprozess ist die Einkoppelfläche 11 oder der Einkoppelabschnitt 11 temporär mit dem erfindungsgemäßen Schutzlack versehen.

Somit kann ein Benutzer, wenn er die erfindungsgemäße Anzeigevorrichtung 1 bestimmungsgemäß auf dem Kopf trägt, das mittels des Bildgebers 6 erzeugte Bild als virtuelles Bild wahrnehmen, wenn er auf den Auskoppelabschnitt 13 blickt. Bei der hier beschriebenen Ausführungsform muss der Benutzer bezogen auf die Blickrichtung G eines Geradeausblicks um ca. 40° nach rechts schauen. In Fig. 2 ist zur Verdeutlichung der Drehpunkt 16 des Auges des Benutzers sowie die Eyebox 17 bzw. die Austrittspupille 17 der Abbildungsoptik 7 eingezeichnet. Die Eyebox 17 ist der Bereich, der durch die Anzeigevorrichtung 1 bereitgestellt wird und in dem sich das Auge des Benutzers bewegen kann und er stets noch das erzeugte Bild als virtuelles Bild sehen kann.

Obwohl bei der beschriebenen Ausführungsform die Einkopplung über die Stirnseite des ersten Brillenglases 3 durchgeführt ist und somit der Einkoppelabschnitt 11 auf der Stirnseite des ersten Brillenglases 3 ausgebildet ist, ist es auch möglich, eine Einkopplung über die Rückseite 15 des ersten Brillenglases durchzuführen.

Wie in der schematischen Darstellung in Fig. 2 gezeigt ist, ist sowohl die Rückseite 15 als auch die Vorderseite 18 des ersten Brillenglases 3 gekrümmt ausgebildet.

Das Optikelement kann wie folgt hergestellt werden:
In einem ersten Schritt wird ein erstes Halbzeug im Spritzguss aus einem thermoplastischen Polymer hergestellt. Das erste Halbzeug kann dann im Bereich einer Mikrostrukturierung mit einer optisch wirksamen Schicht beschichtet werden. Dazu können bekannte Beschichtungsverfahren verwendet werden, wie z. B. ein chemisches Abscheiden aus der Gasphase (CVD) oder ein physikalisches Abscheiden aus der Gasphase (PVD). Die aufgrund der Mikrostrukturierung vorhandenen Vertiefungen, die sich von der zweiten Seite in das Halbzeug hinein erstrecken, können in einem nachfolgenden Schritt so aufgefüllt werden, dass sich eine glatte durchgehende zweite Seite ergibt. Zum Auffüllen der Vertiefungen kann das gleiche Material zur Herstellung des Halbzeuges oder auch ein optischer Kitt oder optischer Klebstoff verwendet werden. Insbesondere kann die erfindungsgemäße Zusammensetzung verwendet werden.

In dem oben beschrieben Herstellungsprozess kann eine optische Fläche, zum Beispiel die Einkoppelfläche 11 oder Einkoppelabschnitt 11 mit dem erfindungsgemäßen Schutzlack versehen werden und im oder nach dem Prozess kann der Schutzlack wieder entfernt werden.

Bei der erfindungsgemäßen Anzeigevorrichtung 1 erfolgt die Einspiegelung des virtuellen Bildes in das Gesichtsfeld des Benutzers über das erste Brillenglas 3. Natürlich ist auch eine Einspiegelung über das zweite Brillenglas 4 möglich. Des Weiteren kann die Anzeigevorrichtung 1 so ausgebildet sein, dass Informationen bzw. virtuelle Bilder über beide Brillengläser 3, 4 eingespiegelt werden. Dabei kann die Einspiegelung so erfolgen, dass ein dreidimensionaler Bildeindruck entsteht. Dies ist jedoch nicht zwingend notwendig.

Die Haltevorrichtung 2 muss nicht als brillenartige Haltevorrichtung ausgebildet sein. Es ist auch jede andere Art der Haltevorrichtung möglich, mit der ein Aufsetzen oder Tragen der Anzeigevorrichtung auf dem Kopf des Benutzers erfolgen kann.

Das Brillenglas kann zweischalig ausgebildet sein. Es ist jedoch auch möglich, das Brillenglas einschalig oder mit mehr als zwei Schalen, z. B. zumindest drei Schalen, herzustellen. Insbesondere kann das Brillenglas aus einem oder zwei Teilen (die nicht notwendigerweise Schalen sein müssen) oder aus mehr als zwei Teilen hergestellt werden.

Die nachfolgenden Beispiele erläutern die Erfindung.

Die folgenden Zusammensetzungen werden durch Mischen der Komponenten der jeweiligen Beispiele bei Raumtemperatur hergestellt. Anschließend wurde mit UV-A-Licht einer Wellenlänge von etwa 365 - 400 nm, erzeugt mit Hilfe eines Hg-Hochdruckstrahlers z. B. Hönle Bluepoint 3, beispielsweise für ca. 60 s bei 30 - 50 mW/cm² oder 30 s bei 100 - 150 mW/cm² (Milliwatt pro Quadratzentimeter) bestrahlt. Als alternative Lichtquelle lassen sich auch UV-LEDs mit Wellenlängen von 365 nm, 375 nm, 385 nm, 395 nm oder 405 nm einsetzen. Bevorzugt werden UV-LEDs mit Wellenlängen von 365 nm, 385 nm oder 405 nm eingesetzt, z. B. Hönle Bluepoint LED.

### Beispiel 1

100 ME TEMPIC
47 ME TTT
5 ME Irgacure 1173
3 ME BHT
3 ME 1-Dodecylamin
0,02 ME Seriplas Red X3B-TP

### Beispiel 2

100 ME PTMP
68 ME TTT
5 ME Irgacure 1700
3 ME 1-Dodecylamin
2 ME BHT

### Beispiel 3

100 ME TEMPIC
100 ME Silbond 600 RST
47 ME TTT
4 ME Irgacure 1173
3 ME Zelec UN
2 ME BHT

### Beispiel 4

100 ME Präpolymer PTMP/XDI (100+12)
51 ME TTT
5 ME Zelec UN
4 ME Irgacure 1173
2 ME BHT

### Beispiel 5

90 ME Präpolymer/XDI (100+12)
46 ME TTT
20 ME Kunstharz SK
2,5 ME Zelec UN
3 ME Irgacure 1173
2 ME BHT

Erläuterungen:

| | |
|---|---|
| ME | Masseneinheit |
| BHT | Butylhydroxytoluol; 2,6-Di-tert-butyl-4-methylphenol |
| Präpolymer PTMP/XDI (100+12) | Präpolymer aus Pentaerythritoltetra(3-mercaptopropionat) und Xylylendiisocyanat im Verhältnis 100+12 |
| TEMPIC | Tris[2-(3-mercaptopropionyloxy)ethyl]isocyanurat |
| TPMP | Trimethylolpropantri(3-mercaptopropionat) |
| TTT | 1,3,5-Triallyl-1,3,5-triazin-2,4,6-trion |
| Zelec UN | Di-(n-dodecyl)-hydrogenphosphat |
| Kunstharz SK | Hydriertes Acetophenon-Formaldehyd-Kunstharz |
| Irgacure 1173, Irgacure 1700 | Fotoinitiatoren |
| Silbond 600 RST | silanisiertes Quarzgutmehl |

Mit den oben beschriebenen Lackzusammensetzungen der Beispiele 1 bis 5 ließen sich schnell härtbare Schutzlacke herstellen, die einen guten Schutz von optischen Flächen bieten und hervorragend wieder entfernbar sind.

## Patentansprüche

1. Lackzusammensetzung, enthaltend
(A) 20 - 79,9 Gew.-%, bezogen auf das Gesamtgewicht der Zusammensetzung, einer Thiolverbindung mit zwei oder mehr Thiolgruppen,
(B) 20 - 79,9 Gew.-%, bezogen auf das Gesamtgewicht der Zusammensetzung, einer Verbindung mit zwei oder mehr Kohlenstoff-Kohlenstoff-Doppelbindungen und
(C) 0,2 - 10 Gew.-%, bezogen auf das Gesamtgewicht der Zusammensetzung, eines Trennmittels, das einen Alkylrest mit 4-20 Kohlenstoffatomen aufweist, wobei der Alkylrest unsubstituiert oder mit Fluor substituiert ist und der Alkylrest an eine funktionelle Gruppe gebunden ist, **dadurch gekennzeichnet, dass** das Trennmittel gewählt ist aus der Gruppe, bestehend aus Alkylmercaptan, Alken, primäres Alkylamin, sekundäres Alkylamin, tertiäres Alkylamin, Alkylphosphat, Dialkylphosphat und Trialkylphosphat.

2. Lackzusammensetzung nach Anspruch 1, **dadurch gekennzeichnet, dass** die Thiolverbindung (A) ein Mercaptoester mit zwei oder mehr Estergruppen und zwei oder mehr Thiolgruppen oder ein Thioether mit zwei oder mehr Thiolgruppen ist.

3. Lackzusammensetzung nach Anspruch 1 oder 2, **dadurch gekennzeichnet, dass** die Komponente (A) Tris-[2-(3-mercaptopropionyloxy)-ethyl]-isocyanurat oder Trimethylolpropan-tri-(3-mercaptopropionat) ist und/oder die Komponente (B) 1,3,5-Triallyl-1,3,5-triazin-2,4,6-trion ist.

4. Lackzusammensetzung nach einem der Ansprüche 1 - 3, **dadurch gekennzeichnet, dass** die Thiolverbindung ein oligomeres Thiourethan ist, erhältlich durch Umsetzung mindestens eines Mercaptoesters, der zwei oder mehr Estergruppen und zwei oder mehr Thiolgruppen aufweist und/oder eines Thioethers, der zwei oder mehr Thiolgruppen aufweist, mit mindestens einem Di- oder Polyisocyanat, wobei das oligomere Thiourethan zwei oder mehr freie Thiolgruppen aufweist.

5. Lackzusammensetzung nach einem der Ansprüche 1 - 4, **dadurch gekennzeichnet, dass** die Lackzusammensetzung zusätzlich 5-25 Gew.-%, bezogen auf das Gesamtgewicht der Zusammensetzung, eines Füllstoffs enthält.

6. Lackzusammensetzung nach einem der Ansprüche 1 - 5, **dadurch gekennzeichnet, dass** das Trennmittel einen Alkylrest oder mehrere Alkylreste aufweist, wobei der eine Alkylrest oder die mehreren Alkylreste zusammen 7-20 Kohlenstoffatome aufweisen.

7. Verfahren zur Herstellung eines Schutzlacks, umfassend die Schritte, dass die Lackzusammensetzung nach einem der Ansprüche 1 - 6 mit einem Fotoinitiator vermischt und anschließend mit Licht einer Wellenlänge ≤ 450 nm bestrahlt wird, wobei die Zusammensetzung aushärtet.

8. Verwendung einer Lackzusammensetzung nach einem der Ansprüche 1 - 6 als Schutzlack auf einer optischen Fläche eines Optikelements bei der Herstellung des Optikelements.

9. Optikelement mit einer optischen Fläche, wobei zumindest ein Teil der optischen Fläche einen Schutzlack aufweist, herstellbar durch Polymerisieren einer Lackzusammensetzung nach einem der Ansprüche 1 - 6.

10. Optikelement nach Anspruch 9, **dadurch gekennzeichnet, dass** die optische Fläche durch einen umlaufenden erhöhten Rand begrenzt ist und der Schutzlack in der sich daraus ergebenden Vertiefung angeordnet ist.

11. Optikelement nach Anspruch 9 oder Anspruch 10, **dadurch gekennzeichnet, dass** es ein Optikelement für eine auf den Kopf eines Benutzers aufsetzbare und ein Bild erzeugende Anzeigevorrichtung (1) ist, wobei das Optikelement
eine Vorderseite (18) und eine Rückseite (15) aufweist,
die optische Fläche eine Einkoppelfläche (11) ist und das Optikelement einen von der Einkoppelfläche (11) beabstandeten Auskoppelabschnitt (13) und
einen Lichtführungskanal (12) aufweist, der dazu geeignet ist, Lichtbündel (9) von Pixeln des erzeugten Bildes, die über die Einkoppelfläche (11) des Optikelementes (3) in das Optikelement (3) eingekoppelt sind, im Optikelement (3) bis zum Auskoppelabschnitt (13) zu führen, von dem sie aus dem Optikelement (3) ausgekoppelt werden.

## Claims

1. A lacquer composition comprising
(A) 20-79.9% by weight, based on the total weight of the composition, of a thiol compound having two or more thiol groups,
(B) 20-79.9% by weight, based on the total weight of the composition, of a compound having two or more carbon-carbon double bonds and
(C) 0.2-10% by weight, based on the total weight of the composition, of a separating agent having an alkyl radical having 4-20 carbon atoms, where the alkyl radical is unsubstituted or fluorine-substituted and the alkyl radical is bonded to a functional group, **characterized in that** the separating agent is selected from the group consisting of alkyl mercaptan, alkene, primary alkylamine, secondary alkylamine, tertiary alkylamine, alkyl phosphate, dialkyl phosphate and trialkyl phosphate.

2. The lacquer composition as claimed in claim, **characterized in that** the thiol compound (A) is a mercapto ester having two or more ester groups and two or more thiol groups or a thioether having two or more thiol groups.

3. The lacquer composition as claimed in claim 1 or 2, **characterized in that** component (A) is tris[2-(3-mercaptopropionyloxy)ethyl] isocyanurate or trimethylolpropane tri(3-mercaptopropionate) and/or component (B) is 1,3,5-triallyl-1,3,5-triazine-2,4,6-trione.

4. The lacquer composition as claimed in any of claims 1-3, **characterized in that** the thiol compound is an oligomeric thiourethane obtainable by reacting at least one mercapto ester having two or more ester groups and two or more thiol groups and/or a thioether having two or more thiol groups with at least one di- or polyisocyanate, where the oligomeric thiourethane has two or more free thiol groups.

5. The lacquer composition as claimed in any of claims 1-4, **characterized in that** the lacquer composition additionally contains 5-25% by weight, based on the total weight of the composition, of a filler.

6. The lacquer composition as claimed in any of claims 1-5, **characterized in that** the separating agent has an alkyl radical or multiple alkyl radicals, where the one or more alkyl radical(s) together have 7-20 carbon atoms.

7. A process for producing a protective lacquer, comprising the steps of mixing the lacquer composition as claimed in any of claims 1-6 with a photoinitiator and then irradiating it with light at a wavelength of ≤ 450 nm to cure the composition.

8. The use of a lacquer composition as claimed any of claims 1-6 as protective lacquer on an optical surface of an optics element in the production of the optics element.

9. An optics element having an optical surface, wherein at least part of the optical surface has a protective lacquer producible by polymerizing a lacquer composition as claimed in any of claims 1-6.

10. The optics element as claimed in claim 9, **characterized in that** the optical surface is bounded by a peripheral elevated edge and the protective lacquer is disposed in the depression that results therefrom.

11. The optics element as claimed in claim 9 or claim 10, **characterized in that** it is an optics element for a display device (1) that can be placed onto a user's head and produces an image, wherein the optics element
has a front side (18) and a rear side (15),
the optical surface is an input surface (11) and the optics element has an output section (13) spaced apart from the input surface (11) and
a light-guiding channel (12) suitable for guiding beams of light (9) of pixels of the generated image that are input into the optics element (3) via the input surface (11) of the optics element (3) within the optics element (3) to the output section (13), from which they are output from the optics element (3).

## Revendications

1. Composition de vernis, contenant
(A) 20 - 79,9% en poids, par rapport au poids total de la composition, d'un composé thiol présentant deux groupes thiol ou plus,
(B) 20 - 79,9% en poids, par rapport au poids total de la composition, d'un composé présentant deux doubles liaisons carbone-carbone ou plus et
(C) 0,2 - 10% en poids, par rapport au poids total de la composition, d'un agent de démoulage qui présente un radical alkyle comprenant 4-20 atomes de carbone, le radical alkyle étant non substitué ou substitué par fluor et le radical alkyle étant lié à un groupe fonctionnel, **caractérisée en ce que** l'agent de démoulage est choisi dans le groupe constitué par alkylmercaptan, alcène, alkylamine primaire, alkylamine secondaire, alkylamine tertiaire, phosphate d'alkyle, phosphate de dialkyle et phosphate de trialkyle.

2. Composition de vernis selon la revendication 1, **caractérisée en ce que** le composé thiol (A) est un mercaptoester présentant deux groupes ester ou plus et deux groupes thiol ou plus ou est un thioéther présentant deux groupes thiol ou plus.

3. Composition de vernis selon la revendication 1 ou 2, **caractérisée en ce que** le composant (A) est l'isocyanurate de tris-[2-(3-mercaptopropionyloxy)-éthyle] ou le tri-(3-mercaptopropionate) de triméthylolpropane et/ou le composant (B) est la 1,3,5-triallyl-1,3,5-triazine-2,4,6-trione.

4. Composition de vernis selon l'une des revendications 1 à 3, **caractérisée en ce que** le composé thiol est un thio-uréthane oligomère pouvant être obtenu par transformation d'au moins un mercaptoester qui présente deux groupes ester ou plus et deux groupes thiol ou plus et/ou d'au moins un thioéther qui présente deux groupes thiol ou plus avec au moins un diisocyanate ou polyisocyanate, le thio-uréthane oligomère présentant deux groupes thiol libre ou plus.

5. Composition de vernis selon l'une des revendications 1 à 4, **caractérisée en ce que** la composition de vernis contient en plus 5-25% en poids, par rapport au poids total de la composition, d'une charge.

6. Composition de vernis selon l'une des revendications 1 à 5, **caractérisée en ce que** l'agent de démoulage présente un radical alkyle ou plusieurs radicaux alkyle, ledit un radical alkyle ou lesdits plusieurs radicaux alkyle présentant ensemble 7-20 atomes de carbone.

7. Procédé de préparation d'un vernis de protection, comprenant les étapes de mélange de la composition de vernis selon l'une des revendications 1 - 6 avec un photo-initiateur et d'exposition consécutive à une lumière d'une longueur d'onde ≤ 450 nm, la composition durcissant.

8. Utilisation d'une composition de vernis selon l'une des revendications 1 - 6 en tant que vernis de protection sur une surface optique d'un élément optique lors de la fabrication de l'élément optique.

9. Élément optique présentant une surface optique, au moins une partie de la surface optique présentant un vernis de protection pouvant être préparé par polymérisation d'une composition de vernis selon l'une des revendications 1 - 6.

10. Élément optique selon la revendication 9, **caractérisé en ce que** la surface optique est délimitée par un bord périphérique surélevé et le vernis de protection est agencé dans le creux ainsi obtenu.

11. Élément optique selon la revendication 9 ou 10, **caractérisé en ce qu'**il s'agit d'un élément optique pour un dispositif d'affichage (1) pouvant être placé sur la tête d'un utilisateur et générant une image, l'élément optique
présentant une face avant (18) et face arrière (15), étant la surface optique d'une surface de couplage (11) et l'élément optique présentant une section de découplage (13) écartée de la surface de couplage (11) et
présentant un canal (12) de guidage de lumière approprié pour guider, dans l'élément optique (3), des faisceaux lumineux (9) de pixels de l'image générée, qui sont couplés par l'intermédiaire de la surface de couplage (11) de l'élément optique (3) dans l'élément optique (3), jusqu'à la section de découplage (13) à partir de laquelle ils sont découplés de l'élément optique (3).
